# FASCICULE DE BREVET EUROPEEN

(11) **EP 0 534 826 B1**
(45) Date de publication et mention de la délivrance du brevet: **15.01.1997**
(21) Numéro de dépôt: 92402570.3
(22) Date de dépôt: 18.09.1992
(51) Int. Cl.: H01P 5/08, G01R 1/067

(54) **Dispositif pour tests hyperfréquences à large bande réalisés in situ**
Einrichtung für in situ Ultrahochfrequenztests mit grosser Bandbreite
Device for in situ ultra-high frequency broadband testing

(30) Priorité: 27.09.1991 FR 9111909
(43) Date de publication de la demande: 31.03.1993
(73) Titulaire: THOMSON-CSF, 75008 Paris (FR)
(72) Inventeur: Cachier, Gérard, Thomson-CSF, SCPI, F-92045 Paris la Defense (FR)
(74) Mandataire: Albert, Claude

(56) Documents cités:
- DD-B- 288 235
- US-A- 4 849 689
- US-A- 4 894 612
- 1989 IEEE MTT-S INTERNATIONALE MICROWAVE SYMPOSIUM-DIGEST, Long Beach, 13-15 juin 1989, vol. 1, pages 823-825, IEEE, New York, US; S.S. OSOFSKY et al.: "A non-contacting probe for measurements on high-frequency planar circuits"
- IEEE TRANSACTIONS ON MICROWAVE THEORY AND TECHNIQUES, vol. 37, no. 3, mars 1989, pages 519-525, New York, US; J.J. BURKE et al.: "Surface-to-surface transition via electromagnetic coupling of microstrip and coplanar waveguide"

## Description

L'invention concerne un dispositif permettant de faire des tests hyperfréquences réalisés in situ, c'est-à-dire en des points arbitraires d'un circuit hybride ou monolithique fonctionnant dans la gamme des hyperfréquences.

Les circuits hybrides ou monolithiques permettent de réaliser des fonctions hyperfréquences complexes qui nécessitent d'être testées à différents niveaux. Cette nécessité provient de la nature intrinsèquement analogique de ces circuits, laquelle entraîne automatiquement des gabarits de réalisation resserrés. Ce besoin est particulièrement critique en hyperfréquences car les longueurs d'onde considérées entraînent un accroissement correspondant de la sensibilité des circuits aux dimensions.

Par ailleurs, les performances demandées aux fonctions hyperfréquences (puissance, facteur de bruit, linéarité, bande passante et caractéristiques de filtrage, précision des modulations, ...) conditionnent directement celles de l'équipement intégrateur et doivent par conséquent être garanties de façon la plus précise possible. Le caractère précurseur de beaucoup de composants hyperfréquences, utilisés parfois en limites de performances, accentue le besoin de tests hyperfréquences.

Jusqu'à présent, on a l'habitude de tester avant montage les composants actifs (diodes, transistors, circuits intégrés) en les faisant travailler en continu, en fonction d'un gabarit donné, et ce dans les phases maquette, prototype et série. Les circuits intégrés peuvent être testés en hyperfréquences grâce à des machines de test sous pointes comme celles vendues par CASCADE MICROWAVE.

Suivant les cas, ces composants actifs sont montés en boîtier, sur un support pour puce testable ("chip carrier"), ou directement en puces dans la fonction hyperfréquences.

Dans les deux premiers cas, un test hyperfréquences est réalisé afin de contrôler les performances finales des composants et parce qu'il est plus facile de comprendre l'origine d'un défaut éventuel et de le réparer.

Les fonctions hyperfréquences sont réalisées dans des boîtiers protecteurs étanches ou hermétiques, munis de connecteurs. Un test est parfois effectué avant la fermeture du boîtier pour des réglages finaux et éventuellement des réparations. Ceci s'applique en particulier aux boîtiers complexes ou de performances critiques.

Finalement, le boîtier est fermé, et testé afin de contrôler les performances du sous-ensemble, de l'ensemble, et de l'équipement intégrateur. Il s'agit là de tests dits d'intégration.

Les tests dits in situ sont ceux que l'on pratique en chaque emplacement de la fonction hyperfréquences. D'un point de vue général, les tests in situ sont utiles car il existe un lien direct entre la topologie d'un circuit hyperfréquences et les fonctions électriques réalisées par celui-ci. Plus précisément, on distingue trois niveaux de besoins pour des test in situ :
- en études ou maquettes, certains couplages entre circuits ou certaines distributions de l'énergie dans les lignes d'alimentation des circuits sont encore mal modélisées, et un outil de mesure de ces énergies permettrait de lever certaines incertitudes de conception ;
- en prototypes, certaines performances ne sont atteintes qu'après réglage. Pour effectuer ces tests, on peut réaliser des boîtiers séparés, que l'on règle et que l'on assemble ensuite. Toutefois cette procédure est coûteuse et de plus ne permet pas de miniaturiser correctement les fonctions hyperfréquences. Un test hyperfréquences in situ permettrait, par exemple, l'adaptation d'amplificateurs montés en cascade sur une céramique, en mesurant la tension existant en un ou plusieurs points des circuits interétages. Un test hyperfréquences in situ permettrait aussi la réalisation de mesures de taux d'ondes stationnaires (TOS) de sortie d'amplificateurs de puissance sans banc de test spécifique ;
- en série, les tests hyperfréquences habituels et les tests sur les alimentations ne permettent pas de localiser les défauts de construction, comme un câblage hyperfréquences défectueux ou même un câblage continu défectueux puisque plusieurs composants sont généralement alimentés en parallèle.

Pour répondre à ces besoins, on a pensé à proposer des dispositifs de test hyperfréquences in situ permettant de résoudre les problèmes de tests notamment des circuits intégrés monolithiques ou hybrides. Ces dispositifs de test in situ doivent permettre des mesures de courants et tensions en des points internes de ces circuits intégrés lorsqu'ils sont en fonctionnement.

Une première solution connue d'après le brevet américain n° 4 849 689 prévoit de réaliser une sonde à ligne de transmission coplanaire venant en contact avec le circuit intégré hyperfréquences à tester.

Une autre solution connue décrite dans l'article "A non-contacting probe for measurements on high-frequency planar circuits" de S.S. OSO FSKY et al. paru dans 1989 IEEE MTT-S international Microwave Symposium-Digest, Long Beach, 13-15 Juin 1989, vol. 1, pages 823-825, IEEE, New-York (U.S.A.) consiste à prévoir une sonde sans contact du champ magnétique existant au-dessus d'une ligne hyperfréquences à microruban ou coplanaire. Cette sonde composée de deux boucles de courant et une ligne de transmission hyperfréquences de sortie est gravée sur un substrat constitué par une plaquette de silicium. Le substrat doit être positionné au-dessus de la ligne hyperfréquences à tester de manière que le champ magnétique traverse une boucle vers le haut et l'autre vers le bas, la contribution des deux boucles s'ajoutant alors. Par contre, pour un champ uniforme induit dans les deux boucles par une source lointaine, par exemple une autre ligne du circuit à tester, les signaux induits ont tendance à s'annuler. L'avantage d'un tel dispositif de test sans détection des signaux induits est qu'il permet de conserver l'information de phase de l'onde hyperfréquences ce qui est très important pour les tests en hyperfréquences.

Cependant cette solution a pour inconvénients que pour assurer un couplage correct par prélèvement avec une ligne hyperfréquences du circuit à tester sans avoir d'effet notable sur le circuit, la sonde et son support doivent être positionnées avec une grande précision au-dessus de la ligne, notamment dans le cas des ondes millimétriques. Par exemple, pour des fréquences de 26,5 à 40 GHz, la sonde doit être placée entre 25 et 50 micromètres au-dessus de la ligne, ce qui est délicat à réaliser et demande un dispositif de positionnement très précis donc coûteux. De plus, la réalisation des gravures sur le substrat n'est pas facilitée par le fait que la surface où se trouvent la sonde et sa ligne de sortie présente des pans coupés.

Un objet de l'invention est donc de réaliser un dispositif de test hyperfréquences in situ exempt de ces inconvénients.

Un autre objet de l'invention est un dispositif de test hyperfréquences où le positionnement précis au-dessus de la ligne testée est automatiquement assuré sans qu'il soit besoin de mécanismes très précis.

Selon l'invention, il est prévu un dispositif pour tests hyperfréquences à large bande réalisés in situ, tel que défini dans les revendications.

L'invention sera mieux comprise et d'autres caractéristiques et avantages apparaîtront à l'aide de la description ci-après et des dessins joints où :
- les figures 1 et 2 représentent, respectivement en coupe et vu de dessus, une première variante à sonde à boucles de courant du dispositif de test selon l'invention ; et
- les figures 3, 4A et 4B représentent une seconde variante à sonde de tension du dispositif de test selon l'invention.

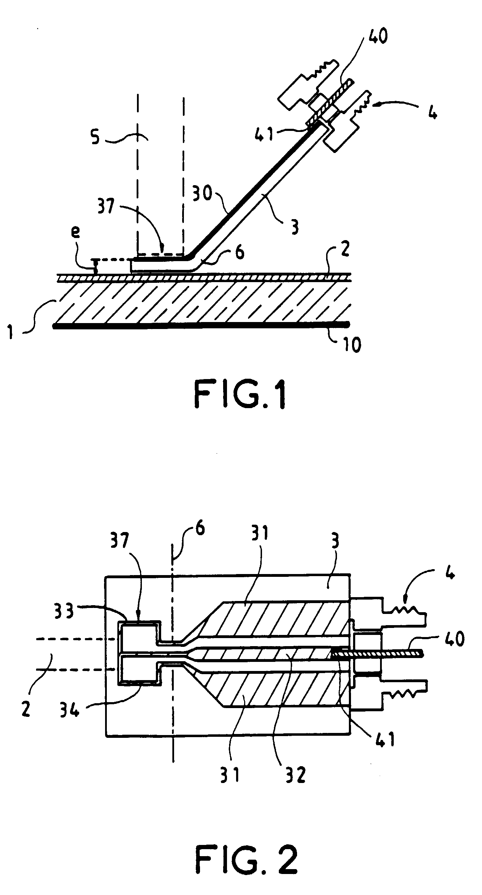

Sur les figures 1 et 2, le circuit hyperfréquences à tester comprend un substrat 1 avec un plan de masse 10 et une ligne microruban 2 dont l'axe longitudinal est dans le plan de coupe de la figure 1.

En fonctionnement hyperfréquences, la ligne hyperfréquences 2 rayonne une onde électromagnétique au-dessus d'elle. La variante des figures 1 et 2 consiste à réaliser un couplage hyperfréquences avec le champ magnétique de l'onde rayonnée.

Le dispositif de test selon l'invention comprend un support 3 en matériau diélectrique souple portant sur sa face supérieure une métallisation 30. Cette métallisation est gravée pour former une sonde 37 à boucles de courant 33 et 34 reliées tête-bêche à une ligne de transmission hyperfréquences de sortie du type coplanaire comportant un ruban central 32 et les plans métalliques de masse 31. La liaison vers un dispositif de mesure extérieur (non représenté) est assurée par un connecteur coaxial classique 4 dont le conducteur central 40 est soudé en 41 au ruban central 32. La face inférieure du support 3 est directement en contact avec la ligne 2 du circuit à tester dans sa partie en vis-à-vis de la sonde à boucles de courant 33, 34. Grâce à sa souplesse, le support 3 est ensuite coudé en 6 pour dégager largement la ligne coplanaire et surtout le connecteur hyperfréquences 4 de la surface du circuit à tester.

De préférence, le contact entre la surface inférieure du support 3 et la ligne 2 est assuré à l'aide d'un dispositif d'appui sensiblement rigide, par exemple une tige 5 en Téflon (marque déposée pour un polytétrafluoroéthylène) à très faibles pertes en hyperfréquences.

Le connecteur 4 et la tige 5 pourraient par exemple être montés solidaires.

Le fonctionnement est le suivant : les boucles 33 et 34 sont disposées au-dessus de la ligne hyperfréquences 2 symétriquement par rapport à l'axe longitudinal de celle-ci. L'épaisseur e du support 3 est déterminée de manière que la sonde 33, 34 soit à la bonne distance de la ligne 2 lorsque la face inférieure du support repose sur celle-ci, de manière à assurer un couplage par prélèvement suffisant (par exemple compris entre -20 dB et -50 dB) sans perturber le fonctionnement hyperfréquences du circuit à tester. Il est ainsi possible d'obtenir un positionnement précis automatique de la sonde au-dessus de la ligne 2. Bien entendu, l'épaisseur e est déterminée pour une bande de fréquence donnée et est différente pour chaque bande.

Le matériau dont est constitué le support 3 doit avoir plusieurs qualités :
- de faibles pertes en hyperfréquences ;
- la possibilité de recevoir une métallisation de surface pour la gravure de la sonde et de la ligne coplanaire ;
- une souplesse suffisante pour permettre le coudage aisé ;
- une résistance mécanique suffisante compte tenu des faibles épaisseurs requises.

Un matériau particulièrement bien adapté est celui connu sous la marque Duroid qui est du Téflon chargé par des fibres de verre.

Comme on l'a déjà expliqué, le champ magnétique au-dessus de la ligne 2 traverse une des boucles 33, 34 vers le haut et l'autre boucle vers le bas de telle sorte que leurs contributions s'ajoutent. Le signal hyperfréquences obtenu est transféré par la ligne coplanaire 31, 32 et le connecteur 4 vers des moyens de mesure qui peuvent déterminer à la fois l'amplitude et la phase de l'onde électromagnétique guidée par la ligne hyperfréquences 2.

On a ainsi un dispositif de test économique et efficace.

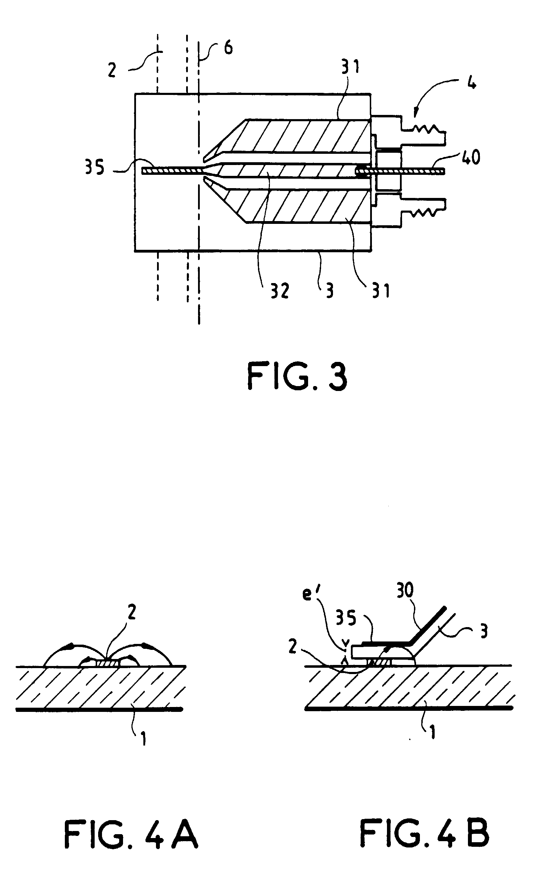

La variante représentée sur les figures 3 et 4A, 4B utilise une sonde de tension pour un couplage au champ électrique de l'onde électromagnétique rayonnée par la ligne hyperfréquences 2.

Les mêmes numéros de référence renvoient aux mêmes éléments que sur les figures 1 et 2.

La sonde de tension utilisée est constituée par un simple conducteur rectiligne 35 servant d'antenne, gravé sur le support 3 et relié au conducteur central 31 de la ligne coplanaire. Les autres éléments du dispositif de test selon l'invention sont identiques à ceux des figures 1 et 2.

La figure 4A représente les lignes de force du champ électrique pour la ligne microruban 2. Pour que l'on obtienne un couplage convenable entre le conducteur 35 et le champ électrique de l'onde rayonnée, il faut que le conducteur 35 soit parallèle aux lignes de force du champ au moins sur une partie de sa longueur.

Il faut donc ici que la sonde soit disposée transversalement par rapport à l'axe longitudinal de la ligne 2.

D'autre part, l'épaisseur e' (Figure 4B) doit être déterminée pour que la condition précédente soit réalisée tout en assurant une valeur de couplage par prélèvement adéquate.

Cette épaisseur dépend de la nature et de l'épaisseur du substrat 1 et des dimensions du ruban 2 elles-mêmes déterminées par les règles connues de réalisation des lignes hyperfréquences.

## Revendications

1. Dispositif pour tests hyperfréquences à large bande réalisés in situ, comportant un support destiné à être placé au-dessus d'une première ligne hyperfréquences rayonnant une onde électromagnétique et des moyens de couplage hyperfréquences portés par ledit support, celui-ci étant disposé par rapport à ladite ligne hyperfréquences de manière telle que lesdits moyens de couplage réalisent, sans contact avec ladite ligne hyperfréquence, un couplage hyperfréquences par prélèvement avec ladite onde électromagnétique, ledit dispositif étant caractérisé en ce que ledit support (3) est constitué en un matériau diélectrique souple, en ce que lesdits moyens de couplage comprennent, sur la face supérieure dudit support, une sonde (33, 34, 35) pour réaliser ledit couplage par prélèvement et une seconde ligne de transmission hyperfréquences (31, 32) pour relier ladite sonde à des moyens (4) de liaison avec des moyens de mesure extérieurs, de sorte que ledit support soit adapté à être appuyé, par la partie de sa face inférieure en vis-à-vis de ladite sonde, sur ladite première ligne hyperfréquences (1, 10, 2), l'épaisseur (e ; e') dudit support étant déterminée pour obtenir ledit couplage par prélèvement.

2. Dispositif selon la revendication 1, caractérisé en ce qu'il comprend en outre des moyens d'appui (5) de ladite partie du support sur ladite première ligne (2).

3. Dispositif selon la revendication 2, caractérisé en ce que lesdits moyens d'appui sont constitués par une tige (5) en matériau diélectrique à faibles pertes en hyperfréquences, sensiblement rigide.

4. Dispositif selon l'une quelconque des revendications 1 à 3, caractérisé en ce que ledit support est constitué par une lamelle en matériau diélectrique souple à faibles pertes en hyperfréquences ayant une face supérieure métallisée (30), lesdits moyens de couplage étant constitués par des gravures sur ladite face supérieure métallisée.

5. Dispositif selon la revendication 4, caractérisé en ce que ledit support est en Duroid.

6. Dispositif selon l'une quelconque des revendications 4 ou 5, caractérisé en ce que ladite seconde ligne hyperfréquences est une ligne coplanaire (31, 32) gravée sur ladite face supérieure métallisée.

7. Dispositif selon la revendication 6, caractérisé en ce que lesdits moyens de liaison (4) comporte un connecteur coaxial dont le conducteur central (40) est relié au ruban central (32) de ladite ligne coplanaire et en ce que ledit support est coudé (6) sensiblement au niveau de la jonction entre ladite sonde et ladite seconde ligne hyperfréquences pour dégager ledit connecteur de la surface de ladite première ligne hyperfréquences.

8. Dispositif selon l'une quelconque des revendications 1 à 7, caractérisé en ce que ladite sonde est une sonde à boucles de courant (33, 34) pour réaliser un couplage au champ magnétique de l'onde hyperfréquences.

9. Dispositif selon la revendication 8, caractérisé en ce que ladite sonde à boucles de courant comporte deux boucles de courant (33, 34) connectées tête-bêche à ladite seconde ligne hyperfréquences et disposées symétriquement de part et d'autre de l'axe longitudinal de ladite première ligne hyperfréquences.

10. Dispositif selon l'une quelconque des revendications 1 à 7, caractérisé en ce que ladite sonde est une sonde de tension (35) pour réaliser un couplage au champ électrique de l'onde hyperfréquences.

11. Dispositif selon la revendication 10, caractérisé en ce que ladite sonde de tension est constituée par un segment rectiligne conducteur (35) formant antenne gravé sur ladite face métallisée et relié par une extrémité au conducteur central (32) de ladite ligne coplanaire (31, 32) de sorte que ledit support soit adapté à être disposé de manière que la direction dudit segment soit sensiblement perpendiculaire à l'axe longitudinal de ladite première ligne hyperfréquences, ladite épaisseur (e') dudit support étant choisi pour que ledit segment soit sensiblement parallèle aux lignes de forces dudit champ électrique au moins sur une partie de sa longueur.

## Patentansprüche

1. Vorrichtung für in situ durchgeführte breitbandige Ultrahochfrequenztests, mit einem Träger, der dazu bestimmt ist, über einer ersten, eine elektromagnetische Welle abstrahlenden Ultrahochfrequenzleitung angeordnet zu werden, und mit von dem Träger getragenen Ultrahochfrequenz-Kopplungsmitteln, wobei der Träger in bezug auf die Ultrahochfrequenzleitung so angeordnet wird, daß die Kopplungsmittel ohne Kontakt mit der Ultrahochfrequenzleitung eine Ultrahochfrequenz-Abgriffskopplung mit der elektromagnetischen Welle realisieren, wobei die Vorrichtung dadurch gekennzeichnet ist, daß der Träger (3) aus einem biegsamen dielektrischen Material gebildet ist, daß die Kopplungsmittel auf der Oberseite des Trägers eine Sonde (33, 34, 35) zur Realisierung der Abgriffskopplung und eine zweite Ultrahochfrequenzleitung (31, 32) zur Verbindung der Sonde mit Mitteln (4) für die Verbindung mit äußeren Meßeinrichtungen aufweisen, so daß der Träger mit dem der Sonde gegenüberliegenden Teil seiner Unterseite auf die erste Ultrahochfrequenzleitung (1, 10, 2) aufgelegt werden kann, wobei die Dicke (e; e') des Trägers so bestimmt ist, daß die Abgriffskopplung erhalten wird.

2. Vorrichtung nach Anspruch 1, dadurch gekennzeichnet, daß sie außerdem Auflagemittel (5) zum Auflegen des Teils des Trägers auf die erste Leitung (2) aufweist.

3. Vorrichtung nach Anspruch 2, dadurch gekennzeichnet, daß die Auflagemittel durch eine Stange (5) aus einem im wesentlichen starren dielektrischen Material mit geringen Ultrahochfrequenzverlusten gebildet sind.

4. Vorrichtung nach einem der Ansprüche 1 bis 3, dadurch gekennzeichnet, daß der Träger durch eine Lamelle aus einem biegsamen dielektrischen Material mit geringen Ultrahochfrequenzverlusten gebildet ist, die eine metallisierte Oberseite (30) hat, wobei die Kopplungsmittel durch Ätzungen auf der metallisierten Oberseite gebildet sind.

5. Vorrichtung nach Anspruch 4, dadurch gekennzeichnet, daß der Träger aus Duroid besteht.

6. Vorrichtung nach einem der Ansprüche 4 oder 5, dadurch gekennzeichnet, daß die zweite Ultrahochfrequenzleitung eine auf der metallisierten Oberseite geätzte koplanare Leitung (31, 32) ist.

7. Vorrichtung nach Anspruch 6, dadurch gekennzeichnet, daß die Verbindungsmittel (4) einen Koaxialverbinder aufweisen, dessen Mittelleiter (40) mit dem Mittelstreifen (32) der koplanaren Leitung verbunden ist, und daß der Träger im wesentlichen auf der Höhe der Verbindungsstelle zwischen der Sonde und der zweiten Ultrahochfrequenzleitung abgewinkelt (6) ist, um den Verbinder von der Oberfläche der ersten Ultrahochfrequenzleitung abzusetzen.

8. Vorrichtung nach einem der Ansprüche 1 bis 7, dadurch gekennzeichnet, daß die Sonde eine Stromschleifensonde (33, 34) ist, um eine Kopplung mit dem Magnetfeld der Ultrahochfrequenzwelle zu realisieren.

9. Vorrichtung nach Anspruch 8, dadurch gekennzeichnet, daß die Stromschleifensonde zwei Stromschleifen (33, 34) enthält, die gegensinnig parallel mit der zweiten Ultrahochfrequenzleitung verbunden und symmetrisch zu beiden Seiten der Längsachse der ersten Ultrahochfrequenzleitung angeordnet sind.

10. Vorrichtung nach einem der Ansprüche 1 bis 7, dadurch gekennzeichnet, daß die Sonde eine Spannungssonde (35) ist, um eine Kopplung mit dem elektrischen Feld der Ultrahochfrequenzwelle zu realisieren.

11. Vorrichtung nach Anspruch 10, dadurch gekennzeichnet, daß die Spannungssonde durch einen geraden Leiterabschnitt (35) gebildet ist, der eine auf der metallisierten Fläche geätzte Antenne bildet und an einem Ende mit dem Mittelleiter (32) der koplanaren Leitung (31, 32) verbunden ist, so daß der Träger so angeordnet werden kann, daß die Richtung des Leiterabschnitts im wesentlichen senkrecht zur Längsachse der ersten Ultrahochfrequenzleitung ist, wobei die Dicke (e') des Trägers so gewählt ist, daß der Leiterabschnitt wenigstens über einen Teil seiner Länge parallel zu den Kraftlinien des elektrischen Feldes ist.

## Claims

1. Device for in-situ microwave broadband testing, including a support intended to be placed above a first microwave line radiating an electromagnetic wave and microwave coupling means carried by the said support, the latter being arranged with respect to the said microwave line in such a way that the said coupling means, without contact with the said microwave line, cause microwave coupling by pick-up with the said electromagnetic wave, the said device being characterized in that the said support (3) consists of a flexible dielectric material, in that the said coupling means comprise, on the upper face of the said support, a probe (33, 34, 35) for causing the said coupling by pick-up and a second microwave transmission line (31, 32) for linking the said probe to means (4) for linking with external measurement means, so that the said support is suitable for being pressed, by the part of its lower face opposite the said probe, onto the said first microwave line (1, 10, 2), the thickness (e; e') of the said support being determined in order to obtain the said coupling by pick-up.

2. Device according to Claim 1, characterized in that it further comprises means (5) for pressing the said part of the support onto the said first line (2).

3. Device according to Claim 2, characterized in that the said pressing means consist of a rod (5) made of a dielectric material having low losses at microwave, and substantially rigid.

4. Device according to any one of Claims 1 to 3, characterized in that the said support consists of a film of flexible dielectric material with low losses at microwave, having a metallized upper face (30), the said coupling means consisting of etchings on the said metallized upper face.

5. Device as claimed in Claim 4, characterized in that the said support is made of Duroid.

6. Device according to either of Claims 4 or 5, characterized in that the said second microwave line is a coplanar line (31, 32) etched on the said metallized upper face.

7. Device according to Claim 6, characterized in that the said linking means (4) include a coaxial connector, the central conductor (40) of which is linked to the central strip (32) of the said coplanar line, and in that the said support is angled (6) substantially at the level of the junction between the said probe and the said second microwave line in order to clear the said connector from the surface of the said first microwave line.

8. Device according to any one of Claims 1 to 7, characterized in that the said probe is a current-loop probe (33, 34) for causing coupling with the magnetic field of the microwave wave.

9. Device according to Claim 8, characterized in that the said current-loop probe includes two current loops (33, 34) connected head to tail to the said second microwave line and arranged symmetrically on either side of the longitudinal axis of the said first microwave line.

10. Device according to any one of Claims 1 to 7, characterized in that the said probe is a voltage probe (35) for causing coupling with the electric field of the microwave wave.

11. Device according to Claim 10, characterized in that the said voltage probe consists of a straight-line conducting segment (35) forming an antenna etched on the said metallized face and linked by one end to the central conductor (32) of the said coplanar line (31, 32) so that the said support is suitable for being arranged in such a way that the direction of the said segment is substantially perpendicular to the longitudinal axis of the said first microwave line, the said thickness (e') of the said support being chosen so that the said segment is substantially parallel to the lines of force of the said electric field at least over a part of its length.
